# EUROPEAN PATENT SPECIFICATION

(11) **EP 3 153 253 B1**
(45) Date of publication and mention of the grant of the patent: **13.01.2021**
(21) Application number: 15188304.8
(22) Date of filing: 05.10.2015
(51) Int. Cl.: B22F 1/00, B22F 3/105, B22F 1/02, B22F 9/04, B22F 9/16, C23G 5/00, B33Y 70/00, B33Y 10/00

(54) **METHOD FOR TREATMENT OF METALLIC POWDER FOR SELECTIVE LASER MELTING**
VERFAHREN ZUR BEHANDLUNG VON METALLPULVER FÜR SELEKTIVES LASERSCHMELZEN
PROCÉDÉ DE TRAITEMENT DE POUDRE MÉTALLIQUE PAR FUSION LASER SÉLECTIVE

(43) Date of publication of application: 12.04.2017
(73) Proprietor: Ansaldo Energia IP UK Limited, London W1G 9DQ (GB)
(72) Inventor: Stankowski, Alexander, 5303 Würelingen (CH); Engeli, Roman, 8050 Zürich (CH)
(74) Representative: Bernotti, Andrea

(56) References cited:
- WO-A1-2014/176045
- DE-A1-102013 206 542
- US-A1- 2014 186 205

## Description

### BACKGROUND OF THE INVENTION

The present invention relates to metallic powder which is used for additive manufacturing processes, especially selective laser melting (SLM). More specifically, the invention refers to a method for treating powder made of Ni-, Co-, Fe- base super alloys or TiAl alloys which is used for manufacturing of three-dimensional articles, for example components for gas turbines, like blades or vanes. Said method can be applied for manufacturing of new powder, for a post conditioning of metallic powder or for recycling/refreshing of already used metallic powder.

### PRIOR ART

There exists a demand in current state of the art for improvement of metallic SLM powder treatments because of the following limiting shortcomings:
a) It is known that the SLM powder quality of different batches - even in the case of the same alloy and the same supplier - tend to show significant variations in the chemical composition and the flowability. This is based on the selected method used for powder generation (gas / water atomization), the type, pureness and dryness of protective gas used for atomization, the type of feedstock material used (master melt or elemental raw materials), its chemical composition/purity and finally on the filling technique and storage in powder containments. Document WO 2012/097794 A1 describes for example a combined powder atomization and SLS manufacturing of a turbine blade within the same manufacturing equipment and under the same atmosphere with the aim of producing a very pure powder which does not change the quality. But this could only be realized if the atmosphere does not vary in pureness.
b) The weldability of highly precipitation strengthened Ni base super alloys is strongly depended on the content of certain critical minor and trace elements, e.g. Si, Zr. This is disclosed by the applicant for example in EP 2886225 A1. Based on the chemical analysis, in most cases commercially available Ni base alloys (in powder form) demonstrate significant concentration differences in respect to these critical elements.
c) The weldability of highly precipitation strengthened Ni base super alloys does also show a correlation with the Al, Ti, and the combined Al and Ti content. Even that this dependency is less pronounced compared with the observed effect for standard welding techniques (TIG, MIG, MAG, LMF, etc.) it also contributes to the overall quality of weld classes achievable by SLM processing.
d) Powder flowability which has an impact on the SLM processibility depends among others on the powder grain size distribution (see for example US 5147448 A, describing techniques for producing fine metal powder), the powder particle shape and the overall humidity content in the powder batch. The latter is also a risk factor for in-situ metal oxide phase formation during laser melting within the SLM building of articles. Specifically conceived powder post treatment sequences are necessary for improvement of said problem.
e) The protective atmosphere within the SLM process chamber can vary in pureness during the overall process time (local leakages, withdrawn oxygen impurities from commercial powder batches, contaminations in the protective gas etc.). This could lead to residual flux (slag) and/or correlated gas inclusions during the SLM processing as a further disadvantage. In document US 2013/0316183 A1 is therefore proposed to add commercially available flux products as separate fraction in a powder mix or as composite particles, but this is rather unfavorable due to the risk of significant flux residues and correlated slug inclusions, pore and crack formation in the SLM microstructure.
f) The powder flowability is - in addition to the grain size distribution (see item d) - further depending on the particle surface condition. SLM powder particles can exhibit very thin (nano scale) closed or only local partial films which can cause a positive or negative impact on the powder flowability (see also Fig. 1) and herewith the SLM processibility. Document US 4944817 A discloses for example the use of coated or blended powder in selective beam sintering, document US 7384447 B2 describes coated Ni-containing powders and complex methods for making such powders in an aerosol stream.
   Surface contaminants may also have an unpredictable influence on the final powder suitability for SLM manufacturing and the yielding SLM article quality (cracks, pores, oxide inclusions, eutectic formation etc.). It is also well known that chemically "ultra cleaned" metallic surfaces, such as by treating Ni base super alloy surfaces with Fluoride Ion Cleaning (FIC) can be welded with improved results. This is partly based on the absence of oxide films, which would otherwise negatively influence the stability of the weld bath (melting bed) zone.
g) If certain elemental additions are needed today to adapt standard SLM powders of Ni base super alloys, for example additions of Nb, Ta, Ti and C for a controlled precipitation of finely granulated and distributed carbide phases, there are only insufficient and uneconomic methods available.
   First of all, the master melt of the standard alloy could be adjusted according to the needs. Especially for low volumes this approach is cost-expensive. Furthermore, it is particularly difficult to control the concentration of certain minor elements, notably if they are prone to oxidation or volatilization.
   The second approach would be to mechanically alloy two or more powder types of defined compositions in a predetermined ratio, but the resulting powder particle shape is a disadvantage. Based on the spattered polygonal shape and wide size distribution, the yielding flowability is strongly inferior to the originally spherical powder fractions, which have been mechanically alloyed. A narrowing of the powder particle size distribution and elimination of fine fraction by sieving will alleviate the negative influence of the latter, but cannot improve the contribution of the disadvantageous impact of the non-sperical particles on the flowability.
   Document WO 2012/055398 A1 relates to components which consist of a material containing at least one refractory metal (Zr, Ti, Hf, V, Nb, Ta, Cr, Mo, W) and include a hard phase and to a method for producing said components, wherein an atmosphere containing at least one reactive gas is used during the melting of the powder in the SLM process to increase the heat resistance of the SLM processed component. The chemical composition of the material is changing during the manufacturing process due to a reaction with the at least one reactive gas. This has the following disadvantages:
   - The un-melted powder in the powder bed is subjected to the reactive gas during at least a part of the build process, which can last several days. This can result in strong change of powder chemistry and makes a reuse of the un-used powder difficult because of the contamination of the un-used powder with the reactive gas.
h) SLM powder recycling is nowadays mainly based on a sieving treatment and might include a regular contribution of a variable fresh powder fraction ratio. No additional methods are available to restore the chemical and physical properties of already used and herewith degenerated SLM powder in a reproducible way. SLM operators have to replace the powder after a defined time, which leads to high cost impact on today's overall SLM processing costs. This fact has additionally an unpredictable and not reproducible impact on the resulting SLM article quality.

US 2014/0186205 discloses an apparatus and a method for reconditioning contaminated residual powder from an additive manufacturing device. The apparatus and method include a reducing chamber that receives contaminated residual powder and removes oxygen to produce reconditioned powder. The reconditioned powder may be stored in a non-oxidizing atmosphere for later reuse.

To summarize it, quality deviations of commercially available SLM powders, together with the fact that commercially available super alloys, for example super alloys based on Ni, Co, Fe or combinations thereof, or commercially available TiAl alloys have to be specifically modified/adapted for the successful application within the SLM processing and high costs resulting from frequent SLM powder replacement in order to reach a specified SLM article quality, lead to a strong demand for improvement of existing SLM powder manufacturing, powder post processing and powder recycling.

### SUMMARY OF THE INVENTION

It is an object of the present invention to provide an effective, simple and cost-efficient method for improvement of SLM powder manufacturing, powder post-processing and powder recycling to overcome the described shortcomings of the prior art methods.

These and other objects are obtained by a method according to independent claim 1.

The method refers in general to treating of SLM powder particles by means of gas phase conditioning.

The disclosed method for treating a base material in form of metallic powder, wherein said powder is made of super alloys based on Ni, Co, Fe or combinations thereof or made of TiAl alloys and wherein the treated powder is then used for additive manufacturing, especially for Selective Laser Melting (SLM) of three-dimensional articles, is characterized in that
- in a first step the chemical composition of the base material is determined and compared to a calculated chemical target composition with detailed amount of each element of the powder, which is necessary for the following SLM manufacturing process,
- the powder is stored and atomized only under dry and pure protective shielding gas atmosphere and
- the powder is treated by a post gas phase treatment, thereby adding or removing specific elements into or from the powder particles and adjusting the content of the added or already existing specific elements to meet the calculated target amount of each element according to the first step, wherein the post gas phase treatment is with fluor containing compounds, preferably PTFE, PFA or partly fluorised silicones.

The method according to claim 1 has the advantage that it allows easily to modify commercial standard alloys in a short time and with relative low costs. A reproducible manufacturing of components with SLM powders could be ensured. With the storage/atomization of the powder under the mentioned conditions an uncontrolled adsorption/contamination of the powder, for example by N₂, O₂, H₂O can be avoided. This is important for the following correct fluorination of the powder in the gas phase. Standard alloys formulations could be adjusted by post processing and yielding particles with a defined compositional gradient. Different SLM powder exhibiting a chemical gradient in contrast to homogeneous composition, that means powder fractions deviating from the alloy specification, could be used, but finally yields in a similar overall alloy composition during the following SLM processing. In addition, it allows manufacturing derivatives of standard alloys in small batches with low cost impact.

It is an advantage that commercially available standard powder (that means new, so far not used powder) and/or already used and therefore degenerated aged powder could be used as the base material. Therefore the method is applicable for new powder for SLM manufacturing of three-dimensional articles, but also for post conditioning and for recycling of metal powder for SLM processes.

The post gas phase treatment is a gas phase treatment with Fluor containing compounds, preferable Polytetrafluorethylene (PTFE), Polyfluoroalkoxy (PFA) or partly fluorised Silicones. With the application of Fluor containing compounds by gas phase treatment very thin film of flux on each powder particle is applied. These films liberate in-situ Fluor by pyrolization (laser energy input), which in-situ removes potential oxide/nitride films, but additionally confer a hydrophobicity to the metallic powder particles during storage. Such a water repellant surface is less prone to physical water adsorption in humid air and dry faster under heat treatment, e.g. within the SLM process chamber or within a pre-het treatment before application in the SLM process.

For treatment of base powder comprising Al, Ti or combinations thereof a most preferred embodiment is to subject said powder to a specific FIC gas phase treatment not only as already known from the prior art for removing surface contaminations and for Al and Ti surface depleting, but according to the invention for adjusting the content of Al and Ti and for depositing of metal fluorides, especially TiF₄, on the surface of the powder, wherein dependent on the FIC cycle parameters a controlled amount of said surface metal fluorides is deposited which act as in-situ flux during the following SLM process. During laser melting this Fluor containing phase removes potential humidity and any resulting oxide phases which might have formed during SLM processing:

TiF₄ + H₂O(g)→TiO₂ + 4HF(g)

MₓO_{y} + HF(g)→MFₙ(g) + H₂O(g)

The change of SLM powder composition including potential local material inhomogeneity by formation of material inclusions which would be otherwise created by commercial flux product additions is avoided. Due to the low amount of fluorides, the volatility of conjugated metal fluorides formed, no or very limited Fluor containing residues are expected within the built SLM article.

In an embodiment of the invention powder which is made of difficult to process Ni base super alloys (alloys, which tend to crack during processing or subsequent heat treatment, typically a function of Al+Ti content) is stored and atomized only under dry and pure protective shielding gas atmosphere under at least Argon 4.8. This has the advantage that alloys free of nitride phases are processed.

It is an advantage when second phase particles as a strengthening phase are applied with the disclosed gas phase treatment on the powder surfaces, especially when the size of the second phase particles is adjusted to the need of the mechanical properties by tailoring the process parameters. As a preferred embodiment finely granulated and distributed carbide, oxide, nitride or carbo-/oxinitrides or intermetallic phases are precipitated as second phase particles during said gas phase treatment. This improves the properties of the manufactured component.

### BRIEF DESCRIPTION OF THE DRAWINGS

The present invention is now to be explained more closely by means of different embodiments and with reference to the attached drawings.
- Fig. 1: shows in a diagram the improvement of flowability by heat treatment up to temperatures of 450 °C for IN738 powder under atmospheric conditions;
- Fig. 2: shows in one embodiment the microstructure of IN738 powder (SEM) after post heat treatment and FIC treatment according to the disclosed method;
- Fig. 3: show in an embodiment EDX results of FIC powder micro-sections;
- Fig. 4: shows an SEM photo of SLM built material MarM247LC with fine and homogeneously distributed carbide precipitations.

### DETAILED DESCRIPTION OF DIFFERENT EMBODIMENTS OF THE INVENTION

The present invention provides an effective, simple and cost-efficient method for improvement of SLM powder manufacturing, powder post-processing and powder recycling to overcome the described shortcomings of the prior art methods. More specifically, the method refers in general to the treating of SLM powder particles by means of gas phase conditioning.

The disclosed method for treating a base material in form of metallic powder, wherein said powder is made of super alloys based on Ni, Co, Fe or combinations thereof or made of TiAl alloys and wherein the treated powder is then used for additive manufacturing, especially for Selective Laser Melting (SLM) of three-dimensional articles, is characterized in that
- in a first step the chemical composition of the base material is determined and compared to a calculated target chemical composition with detailed amount of each element of the powder, which is necessary for the following SLM manufacturing process,
- the powder is stored and atomized only under dry and pure protective shielding gas atmosphere and
- the powder is treated by a post gas phase treatment, thereby adding or removing specific elements into or from the powder particles and adjusting the content of the added or already existing specific elements to meet the calculated target amount of each element according to the first step, wherein the post gas phase treatment is with fluor containing compounds, preferably PTFE, PFA or partly fluorised silicones.

The detailed determination of the amount of the elements (first step of the method) could be done by any method according to the state of the art, for example by EDX (Energy Dispersive X-ray Spectroscopy).

The mentioned post gas phase treatment is a gas phase treatment with Fluor containing compounds, preferable Polytetrafluorethylene (PTFE), Perfluoroalkoxy (PFA) or partly fluorised Silicones. In addition, a post heat treatment under atmospheric conditions for improvement of the flowability of the powder is also possible.

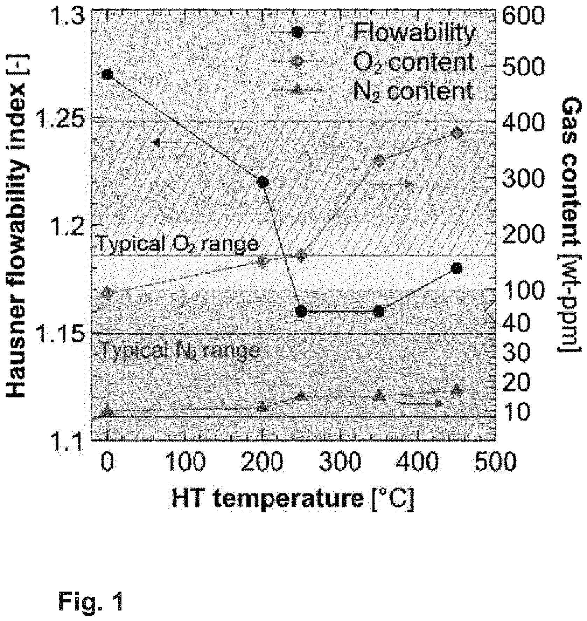

In Fig.1 is shown the improvement of the flowability of commercially available IN738 powder (as delivered), a Ni based superalloy with the following results of EDX analysis (in wt-%):, 2.75 Al, 3.31 Ti, 12.91 Cr, 7.07 Co, 0.52 Nb, 1.57 Mo, 1.00 Ta. 2.22 W and 52.17 Ni by means of a heat treatment in the range from 0-450 °C under atmospheric conditions. In addition, the gas content (typical O₂ and N₂ range) is shown in that temperature range. The partly oxidized/nitrided powder shows an improved flowability.

According to Fig. 1 the Hausner Index (defined as tapped density/apparent density) decreases with increasing heat temperature (each 1 hour, air). A low Hausner Index means a better flowability. The improvement of flowability is caused by the oxidation layer, which decreases the cohesion power between the particles. Therefore, a powder with a low flowability or a powder with a fine particle size distribution could be improved (higher flowability) without increasing the oxygen content to much (see "typical 02 content" in Fig. 1).

For treatment of base powder comprising Al, Ti or combinations thereof a most preferred embodiment is to subject said powder to a specific FIC gas phase treatment not only as already known from the prior art for removing surface contaminations and for Al and Ti surface depleting, but according to the invention for adjusting the content of Al and Ti and for depositing of metal fluorides, especially TiF₄, on the surface of the powder, wherein dependent on the FIC cycle parameters a controlled amount of said surface metal fluorides is deposited which also act as in-situ flux during the following SLM process. During laser melting this Fluor containing phase removes potential humidity and any resulting oxide/nitride phases which might have formed during SLM processing:

TiF₄ + H₂O(g)→TiO₂ + 4HF(g)

MₓO_{y} + HF(g)→MFₙ(g) + H₂O(g)

The change of SLM powder composition which would be otherwise created by commercial flux product additions is avoided. Due to the low amount of fluorides, the volatility of conjugated metal fluorides formed, no or very limited Fluor containing residues are expected within the built SLM article.

In a first embodiment, commercially available IN738 powder, stored in a small welded metal box (steel), was post heat treated at 500°C/1h/Air and then a FIC cleaning with special parameters (p, T, t, gas composition) was done (= HT+FIC). The heat treatment results in at least partly oxidized powder and with the following FIC the "oxide/nitride skin" (including any other surface contaminations) is removed. The used specific FIC process regime results in a partial fluorisation of the Ni powder without unwanted secondary effects.

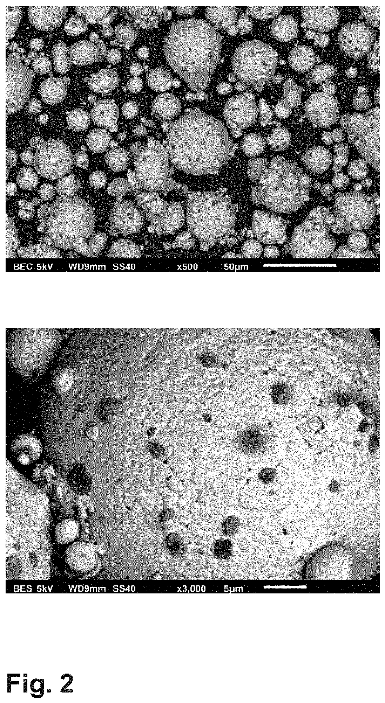

Fig. 2 shows the microstructure in SEM (Scanning Electron Microscope) with two different enlargement factors of the powder particles after such FIC treatment. Fine Fluoride particles (TiF₄) could be clearly seen on the particle surface, the Ti content on the surface was increased. In addition, an enrichment of Nb, Ta and C, and a depletion of Al and Ti at least on the surface (achieving a concentration gradient) of the powder particles were investigated.

The latter one was also the result of comparison of the microstructure of the powder after heat treatment and after heat treatment plus FIC treatment. As result of the strong attack of the surface region of the powder which was FIC treated there was a depletion of Al and Ti.

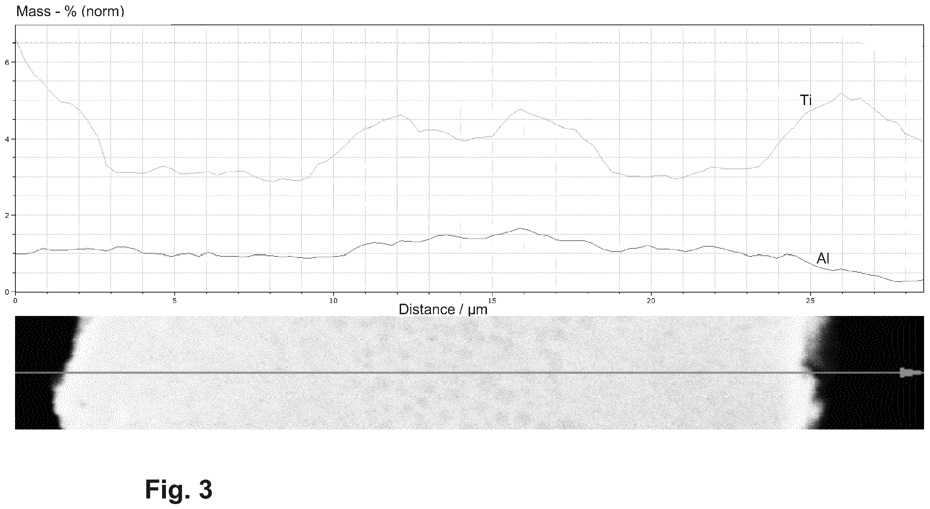

In a second embodiment IN738LC powder from a different supplier was heat treated under atmospheric conditions and then FIC treated and ball milled (BM). SEM and EDX (Energy Dispersive X-ray Spectroscopy) investigations show also a depletion of Al and Ti in the surface region, in the center were observed gamma prime particles (see Fig. 3). In addition, elongated needle like areas enriched in Ti, Nb, Ta could be seen, which would be typical for MC carbides (= HT+FIC+BM).

In a third embodiment IN738LC powder as delivered was FIC treated in a metal container with TBC powder, for example Y₂O₃ stabilized or pure ZrO₂, on the bottom (= FIC+TBC).

With such variably treated powder a SLM processing (single layer processing, small grooves with width of 1 cm and depth of 80 µm) was done with the following parameters:
Laser power: 300 W
Scan speed: 1600 mm/s
Hatch distance: 0.07 mm

After cutting, grinding, polishing and etching (electrolytically H₃PO₄) of the SLM processed probes they were inspected by light microscopy and SEM of surface and microsections. The surface under the light microscope of the different probes showed no significant differences. SEM tests showed that the amount of surface oxides is varying according to the gas phase treatment. The FIC+TBC embodiment shows small and less oxides than the other ones and mostly dense oxide precipitations. In addition, no cracks were detected within the metallurgically investigated probes. This treatment seems to be the best one.

Dependent on the post gas phase treatment parameters (p, T, t, gas composition) there was detected a depletion of Ti, Al in the outer area and an enrichment of Ti and also some Nb, Ta, C on the surface. This has an influence on the weldability of the material as well as on formation of the oxides (amount, position) during the welding.

The disclosed method allows easily modifying commercial standard alloys in a short time and with relative low costs. A reproducible manufacturing of components with SLM powders could be ensured. Standard alloys formulations could be adjusted by post processing and yielding particles with a defined compositional gradient. Different SLM powder exhibiting a chemical gradient in contrast to homogeneous composition, that means powder fractions deviating from the alloy specification, could be used, but finally yields in a similar overall alloy composition during the following SLM processing. In addition, it allows manufacturing derivatives of standard alloys in small batches with low cost impact.

Both commercially available standard powder (that means new, so far not used powder) and already used and therefore degenerated aged powder could be used as the base material. Therefore the method is applicable for new powder for SLM manufacturing of three-dimensional articles, but also for post conditioning and for recycling of metal powder for SLM processes.

In an embodiment of the invention powder which is made of difficult to process Ni base superalloys is stored and atomized only under dry and pure protective shielding gas atmosphere under at least Argon 4.8. This has the advantage that alloys free of nitride phases are processed.

It is an advantage when second phase particles as a strengthening phase are applied with the disclosed gas phase treatment on the powder surfaces, especially when the size of the second phase particles is adjusted to the need of the mechanical properties by tailoring the process parameters. As a preferred embodiment finely granulated and distributed carbide, oxide, nitride or carbo-/oxinitrides or intermetallic phases are precipitated as second phase particles during said gas phase treatment. This improves the properties of the manufactured component.

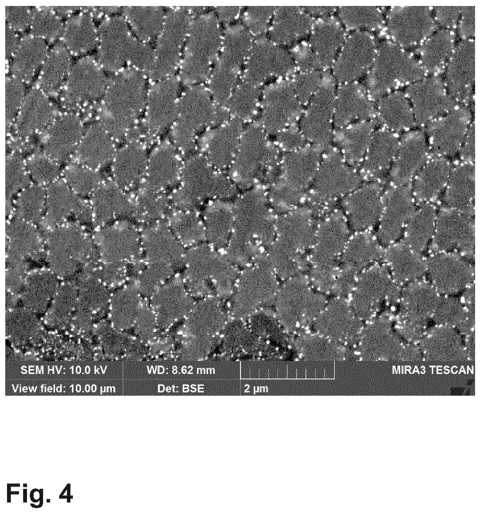

Fig. 4 is a SEM photo of MarM247LC, a well-known commercially available material, after SLM processing. Fine carbide precipitations at dendrite boundaries could be seen.

In addition, in a further embodiment of the invention, the powder is subjected to a fluorised Silicone gas post treatment to adjust the Si content which is critical for the weldability of Ni base superalloy powder.

The adjustment of Si content should be on the lowest acceptable level for the Ni base super alloy composition. Preferentially, the Ni base alloy powder to be used for fluorination shall be free of Si. The necessary Si concentration is reached by post gas treatment.

Of course, the invention is not limited to the described exemplary embodiments.

## Claims

1. Method for treating a base material in form of metallic powder made of super alloys based on Ni, Co, Fe or combinations thereof, or made of TiAl alloys which treated powder is used for additive manufacturing, especially for Selective Laser Melting (SLM) of three-dimensional articles, **characterized in that**
- in a first step the chemical composition of the base material is determined and compared to a calculated target chemical composition with detailed amount of each element of the powder, which is necessary for the following SLM manufacturing process,
- the powder is stored and atomized only under dry and pure protective shielding gas atmosphere and
- the powder is treated by a post gas phase treatment, thereby adding or removing specific elements into or from the powder particles and adjusting the content of the added or already existing specific elements to meet the calculated target amount of each element according to the first step, wherein the post gas phase treatment is with Fluor containing compounds, preferably PTFE, PFA or partly fluorised Silicones.

2. Method according to claim 1, **characterized in that** commercially available standard powder and/or already used and therefore degenerated powder is used as the base material.

3. Method according to claim 1, **characterized in that** the powder made of difficult to process Ni base super alloys is stored and atomized only under dry and pure protective shielding gas atmosphere under at least Argon 4.8.

4. Method according to claim 1, **characterized in that** the base powder comprising Al, Ti or combinations thereof is subjected to a specific FIC post gas phase treatment for
- removing surface contaminations,
- Al and Ti surface depleting, thereby adjusting the content of Al and Ti and
- depositing of metal fluorides, especially TiF₄, on the surface of the powder,
wherein dependent on the FIC cycle parameters (p, T, t, gas composition)a controlled amount of said surface metal fluorides is deposited which act as in-situ flux during the following SLM process.

5. Method according to claim 1, **characterized in that** the post gas phase treatment is applied to deposit second phase particles as a strengthening phase on the powder surfaces, wherein the size of the second phase particles is adjusted to the need of the mechanical properties by tailoring the process parameters of the fluorizing process.

6. Method according to claim 5, **characterized in that** during said gas phase treatment finely granulated and distributed carbide, oxide, nitride or carbo-/oxinitrides or intermetallic phases are precipitated as second phase particles.

## Patentansprüche

1. Verfahren zur Behandlung eines Basismaterials in Form eines Metallpulvers, das aus auf Ni, Co, Fe oder Kombinationen daraus basierenden Superlegierungen hergestellt ist oder aus TiAl-Legierungen hergestellt ist, wobei das behandelte Pulver zur additiven Fertigung, insbesondere für selektives Laserschmelzen (SLM) von dreidimensionalen Gegenständen verwendet wird, **dadurch gekennzeichnet, dass**
- in einem ersten Schritt die chemische Zusammensetzung des Basismaterials ermittelt und mit einer berechneten chemischen Soll-Zusammensetzung mit einer detaillierten Menge jedes Elements des Pulvers, das für den nachfolgenden SLM-Fertigungsprozess erforderlich ist, verglichen wird,
- das Pulver nur unter einer trockenen und reinen schützenden Schutzgasatmosphäre gelagert und zerstäubt wird und
- das Pulver durch eine Nach-Gasphasenbehandlung behandelt wird, wodurch zu den Pulverpartikeln spezifische Elemente hinzugefügt oder aus diesen entfernt werden und der Gehalt der hinzugefügten oder bereits vorhandenen spezifischen Elemente eingestellt wird, um die berechnete Sollmenge jedes Elements gemäß dem ersten Schritt zu erreichen, wobei die Nach-Gasphasenbehandlung mit Fluor enthaltenden Verbindungen, vorzugsweise PTFE, PFA oder teilweise fluorierten Silikonen erfolgt.

2. Verfahren nach Anspruch 1, **dadurch gekennzeichnet, dass** handelsübliches Standardpulver und/oder bereits verwendetes und daher degeneriertes Pulver als das Basismaterial verwendet wird.

3. Verfahren nach Anspruch 1, **dadurch gekennzeichnet, dass** das aus schwer zu verarbeitenden Superlegierungen auf Ni-Basis hergestellte Pulver nur unter einer trockenen und reinen schützenden Schutzgasatmosphäre unter zumindest Argon 4,8 gelagert und zerstäubt wird.

4. Verfahren nach Anspruch 1, **dadurch gekennzeichnet, dass** das Al, Ti, oder Kombinationen daraus enthaltende Basispulver einer spezifischen FIC-Nach-Gasphasenbehandlung zum
- Entfernen von Oberflächenverunreinigungen,
- Al- und Ti-Oberflächenabreichern, wodurch der Gehalt an Al und Ti eingestellt wird, und
- Abscheiden von Metallfluoriden, insbesondere TiF₄ auf der Oberfläche des Pulvers
unterzogen wird, wobei in Abhängigkeit von den FIC-Zyklusparametern (p, T, t, Gaszusammensetzung) eine kontrollierte Menge der Oberflächenmetallfluoride abgeschieden wird, die als in-situ-Flussmittel während des nachfolgenden SLM-Prozesses wirken.

5. Verfahren nach Anspruch 1, **dadurch gekennzeichnet, dass** die Nach-Gasphasenbehandlung angewandt wird, um Zweite-Phase-Partikel als eine Festigungsphase auf den Pulveroberflächen abzuscheiden, wobei die Größe der Zweite-Phase-Partikel auf die Erfordernisse der mechanischen Eigenschaften durch spezifische Anpassung der Prozessparameter des Fluorierungsprozesses eingestellt wird.

6. Verfahren nach Anspruch 5, **dadurch gekennzeichnet, dass** während der Gasphasenbehandlung fein granuliertes und verteiltes Carbid, Oxid, Nitrid oder Carbo-/Oxinitride oder Zwischenmetallphasen als Zweite-Phase-Partikel ausgefällt werden.

## Revendications

1. Procédé pour traiter un matériau de base sous forme de poudre métallique faite de superalliages à base de Ni, Co, Fe ou leurs combinaisons, ou faite d'alliages de TiAl, laquelle poudre traitée est utilisée pour la fabrication d'additifs, en particulier pour la fusion sélective par laser (SLM) d'articles tridimensionnels, **caractérisé en ce que**
- dans une première étape, la composition chimique du matériau de base est déterminée et comparée à une composition chimique cible calculée avec une quantité détaillée de chaque élément de la poudre, qui est nécessaire pour le traitement de fabrication SLM suivant,
- la poudre est stockée et atomisée uniquement dans une atmosphère gazeuse formant écran protecteur pure et sèche et
- la poudre est traitée par un post-traitement en phase gazeuse, qui ainsi ajoute ou retire des éléments spécifiques dans ou hors des particules de poudre, et ajuste la teneur en les éléments spécifiques ajoutés ou déjà existants pour qu'elle corresponde à la quantité cible calculée de chaque élément conformément à la première étape,
dans lequel le post-traitement en phase gazeuse est effectué avec des composés fluorés, de préférence le PTFE, le PFA ou des silicones partiellement fluorées.

2. Procédé selon la revendication 1, **caractérisé en ce qu'**une poudre standard disponible dans le commerce et/ou une poudre déjà utilisée et par conséquent dégénérée est utilisée en tant que matériau de base.

3. Procédé selon la revendication 1, **caractérisé en ce que** la poudre faite de superalliages à base de Ni difficiles à traiter est stockée et atomisée uniquement dans une atmosphère gazeuse formant écran protecteur pure et sèche sous au moins de l'argon 4.8.

4. Procédé selon la revendication 1, **caractérisé en ce que** la poudre de base comprenant de l'Al, du Ti ou leurs combinaisons est soumise à un post-traitement en phase gazeuse FIC spécifique pour
- retirer les contaminations en surface,
- appauvrir la surface en Al et Ti, en ajustant ainsi la teneur en Al et Ti, et
- déposer des fluorures métalliques, en particulier TiF₄, sur la surface de la poudre, dans lequel, en fonction des paramètres de cycle FIC (p, T, t, composition du gaz), une quantité contrôlée desdits fluorures métalliques de surface est déposée, laquelle agit comme un flux in situ durant le traitement SLM qui suit.

5. Procédé selon la revendication 1, **caractérisé en ce que** le post-traitement en phase gazeuse est appliqué pour déposer des particules d'une deuxième phase en tant que phase de renforcement sur les surfaces de la poudre, dans lequel la taille des particules de la deuxième phase est ajustée aux besoins des propriétés mécaniques par adaptation des paramètres de traitement du procédé de fluoration.

6. Procédé selon la revendication 5, **caractérisé en ce que**, durant ledit traitement en phase gazeuse, des phases intermétalliques ou de carbure, oxyde, nitrure ou carbo-/oxynitrure, finement granulées et distribuées, sont précipitées en tant que particules de la deuxième phase.
